# EUROPEAN PATENT SPECIFICATION

(11) **EP 2 256 233 B1**
(45) Date of publication and mention of the grant of the patent: **23.01.2013**
(21) Application number: 10004780.2
(22) Date of filing: 06.05.2010
(51) Int. Cl.: C25D 17/00, C25D 17/08, C23C 16/54, C25D 19/00, C23C 14/56

(54) **An apparatus for deposition of coating films**
Vorrichtung zur Abscheidung von Überzugsschichten
Dispositif pour le dépôt de films de revêtement

(30) Priority: 27.05.2009 IT MI20090933
(43) Date of publication of application: 01.12.2010
(73) Proprietor: Protec Surface Technologies S.r.L., 25081 Bedizzole (BS) (IT)
(72) Inventor: Pitacco, Fabrizio, 25081 Bedizzole (Brescia) (IT); Tosti, Michele, 25081 Bedizzole (Brescia) (IT)
(74) Representative: Lunati, Valerio

(56) References cited:
- EP-B1- 1 129 232
- US-A1- 2005 279 642
- US-A1- 2009 008 259

## Description

The present invention relates to an apparatus for deposition of coating films of the type pointed out in the preamble of the first claim.

Presently known are different processes and apparatuses for film or coating deposition on various objects and articles of manufacture.

In particular, galvanic processes are known as well as high-vacuum processes, such as the CVD and PVD processes.

In galvanic processes the objects to be coated are disposed on suitable frames and dipped into a galvanic or electrolytic bath consisting of an aqueous solution in which substances increasing the electric conductivity are dissolved, and are connected to a current generator in such a manner that they can constitute a cathode for the reaction hereinafter described.

In the same bath an anode of a particular material is further placed, mainly made of the material that is intended to be used for the coating or film.

When the electric circuit between anode and cathode is closed, metallic atoms from the anode are laid down on the cathode, as a result of oxidation-reduction reactions, which atoms will form a surface film or coating.

The galvanic process creates homogeneous films of a thickness included between hundredths of one micron and tens of microns and usually they are utilised so as to protect metal structures and articles of manufacture from corrosion and give them particular aesthetic features.

Also known are thin-film deposition methods through high-vacuum processes, in particular belonging to the PVD and/or CVD families.

In these processes the materials constituting the thin films are made available by means of different technologies and are then laid down in a high-vacuum environment on the surfaces to be coated.

In particular, processes referred to as PVD (Physical Vacuum Deposition) are known.

In PVD processes the materials that have to constitute the film are made available inside the volume of a vacuum chamber in which the surfaces to be coated are positioned, in the form of gases, vapours and/or particles for example.

The surfaces to be coated are generally fastened to frames set in motion, for instance in rotation, on suitable supports, at the inside of the vacuum chamber itself.

Then the particles or the like present inside the chamber come into contact with the surfaces to be coated to which they adhere.

Generally, by means of PVD techniques it is possible for example to lay down pure or alloy metals, nitrides, carbonitrides or oxides and others.

Also known are processes referred to as CVD (Chemical Vapour Deposition) processes, that are similar to PVD processes.

In CVD processes chemical precursors of the materials that will have to constitute the film are used, i.e. materials that, following foreseen chemical reactions, will compose the film.

These materials are then diffused within a vacuum chamber in which the surfaces to be coated, preferably set in motion, are placed.

The precursor then comes into contact with the surfaces to be coated on which it decomposes giving rise to a film with the desired composition.

Said high-vacuum processes give particular aesthetic and surface properties to the articles of manufacture.

Due to the different important properties that the galvanic processes and high-vacuum processes give to the films laid down on objects, the two processes are frequently combined in succession.

In these cases the galvanic process is used to give resistance to corrosion, while the high vacuum process, preferably carried out subsequently, gives important surface features such as an excellent aesthetic appearance due to a particular coloration and an improved resistance to wear.

The known art mentioned above has some important drawbacks.

In fact, for applying both processes, i.e. the galvanic and high-vacuum processes on the elements, a considerable work cycle is required, in particular by qualified workers.

Actually, it is necessary to mount the elements or articles of manufacture on frames supporting the elements during the galvanic processes, then dismantle them and remount them again on frames supporting the elements during the high-vacuum processes. Patent application US-A-2005/0279642 partially solve this problem, but the process still remains slow. Afterwards it is necessary to dispose the last-mentioned frames with the elements to be positioned inside the high-vacuum chamber, and remove the frames therefrom when the process has been completed to lastly dismantle the elements or articles of manufacture.

This great number of operations greatly slow down production and increases the costs of same.

In addition, handling of the elements and, possibly, the prolonged exposure of same to the atmosphere between a process and the following one can give rise to surface-oxidation phenomena, bringing about an increase in the rejected articles, making it necessary to carry out a further intermediate process of washing and surface activation that will cause slowing down of the production and increase in costs, as well as a greater environmental pollution.

To conclude, these working operations involve use of supports or supporting frames that are different for the galvanic processes and the vacuum processes, so that costs will be further increased.

An alternative solution to use in succession of the two processes consists in carrying out a chromium plating through a galvanic process.

This chromium plating is classically obtained by means of electrolytic baths in which hexavalent chromium is present and gives the typical metallic chromium coloration and good surface features to the coated objects.

However this chromium plating with hexavalent chromium involves toxicity problems and consequently is being progressively eliminated from industrial processes.

It is in particular replaced by chromium plating with trivalent chromium which however has worse aesthetic and surface features than chromium plating with hexavalent chromium.

Under this situation the technical task underlying the present invention is to devise a deposition apparatus enabling coating films to be made that are able to substantially obviate the mentioned drawbacks.

Within the scope of this technical task it is an important aim of the invention to conceive an apparatus for deposition of coating films allowing coating films to be quickly made which have the advantages of the films obtained by means of combined galvanic processes and high-vacuum processes.

A further important aim of the invention is to obtain a surface coating having the aesthetic and surface features typical of a chromium plating obtained with hexavalent chromium but devoid of the related toxicity drawbacks in workings. The technical task mentioned and the aims specified are achieved by an apparatus for deposition of coating films as claimed in the appended claim 1. Preferred embodiments are highlighted in the sub-claims.

The features and advantages of the invention are hereinafter clarified by the detailed description of a preferred embodiment of the invention, with reference to the accompanying drawings, in which:
**Fig. 1** is a perspective view of a minimal example of an apparatus for deposition of coating films according to the invention;

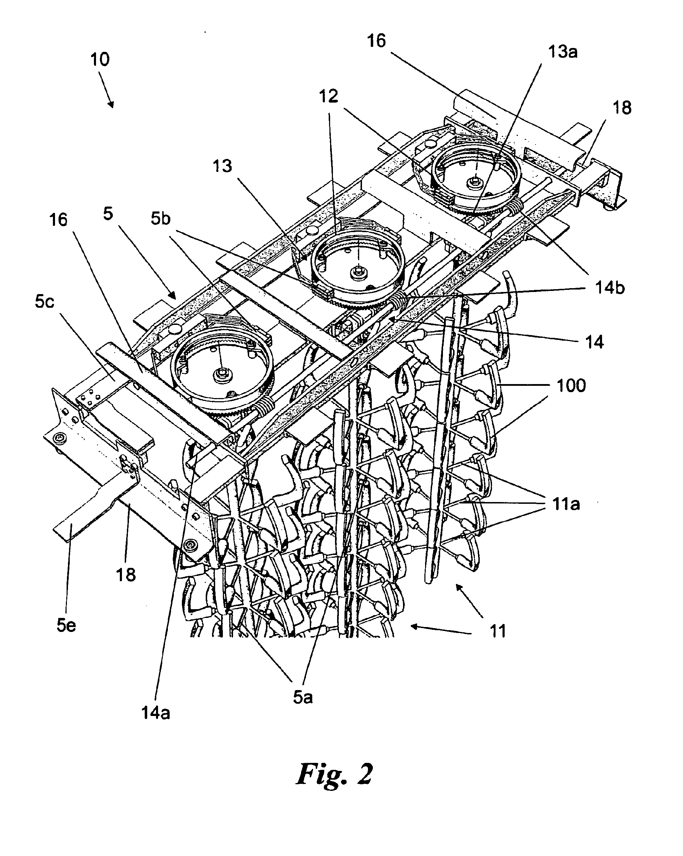

**Fig. 2** shows a first portion of the apparatus for deposition of coating films;
**Fig. 3** shows a second portion of the apparatus for deposition of coating films;
**Fig. 4** shows a third portion of the apparatus for deposition of coating films;
**Fig. 5** is a fourth portion of the apparatus for deposition of coating films:

**Fig. 6** reproduces a fifth portion of the apparatus for deposition of coating films; and

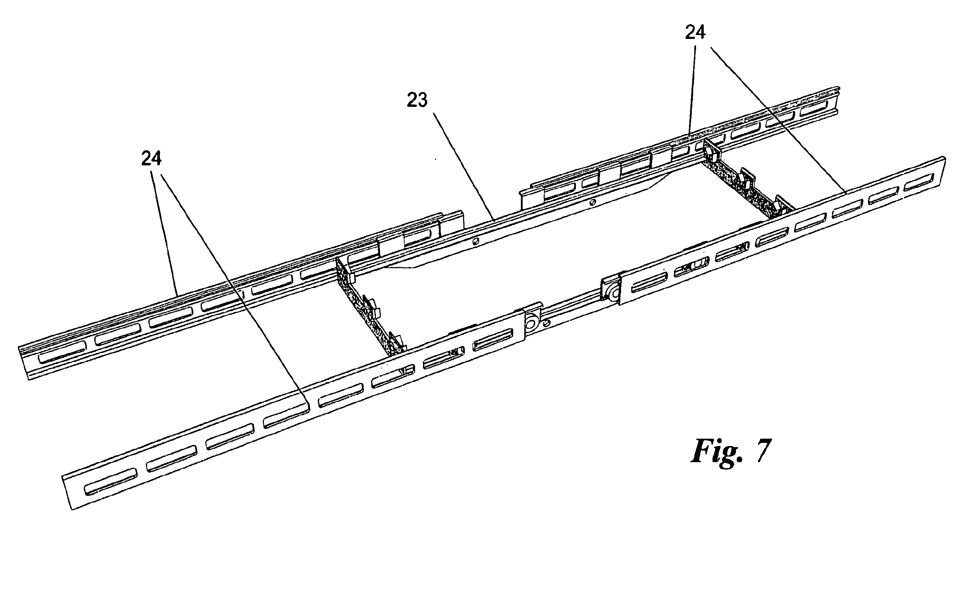

**Fig. 7** diagrammatically shows a sixth portion of the apparatus for deposition of coating films;
**Fig. 8** is a further portion of the apparatus for deposition of coating films;
**Fig. 9** diagrammatically shows an object coated by means of the apparatus in accordance with the invention; and
**Fig. 10** is a perspective view of an alternative embodiment of the apparatus for deposition of coating films in accordance with the invention.

With reference to the mentioned figures, the apparatus for deposition of coating films according to the invention is generally identified with reference numeral **1.** It is adapted to cover objects to be coated **100** with a coating film **101,** made up of at least one galvanic film **102** and at least one thin film **103** preferably suitable to constitute the outer surface of the objects 100.

As an alternative, the thin film 103 is placed under the galvanic film 102 that will constitute the outer surface.

Apparatus 1 comprises a device for deposition of galvanic coatings **2** and at least one device for deposition of high-vacuum coatings **3.**

Said two devices 2 and 3 are placed in succession in a manner adapted to obtain a single deposition apparatus 1 for laying down coating films 101.

In particular, the device for deposition of galvanic coatings 2 is adapted to put into practice galvanic processes leading to obtaining galvanic films 102 on the objects to be coated 100.

As known, the galvanic processes comprise a step of introducing the objects to be coated 100 into an electrolytic bath **4,** preferably consisting of an aqueous solution into which substances increasing the electric conductivity thereof are dissolved.

The objects to be coated 100 are also connected to an electric source, through electric connections **5** to be described in the following, so that the objects 100 themselves can constitute a cathode for the oxidation-reduction reaction taking place in the galvanic processes.

The galvanic processes can further comprise the steps of preparing, pickling and cleaning the objects 100 in suitable preparation baths **6.**

The device for deposition of galvanic coatings 2 therefore comprises at least a first vat **4a** for containing the electrolytic bath 4 and preferably further vats **6a** for containing the preparation baths 6.

Said vats 4a and 6a are preferably in the form of parallelepipeds and have the upper face clear, so that the objects 100 can be introduced therethrough.

The device further comprises actuating means **7** for moving the objects 100, such as in particular a first carriage or trolley **8** adapted to translate the objects 100 in a first horizontal direction **2a,** so as to enable translation of said objects 100 between the vats 4a and 6a, as well as in a vertical direction **2b** in a manner adapted to allow the objects 100 to be dipped into the vats 4a and 6a and to be removed therefrom.

Trolley 8 in particular comprises an outer structure **8a** suitable to move on rails **9** disposed in said first direction 2a, and an inner structure **8b** suitable to move in a vertical direction 2b, independently of the outer structure 8a.

The inner structure 8b in particular comprises two hooking elements **8c** that preferably can be moved close to and away from each other.

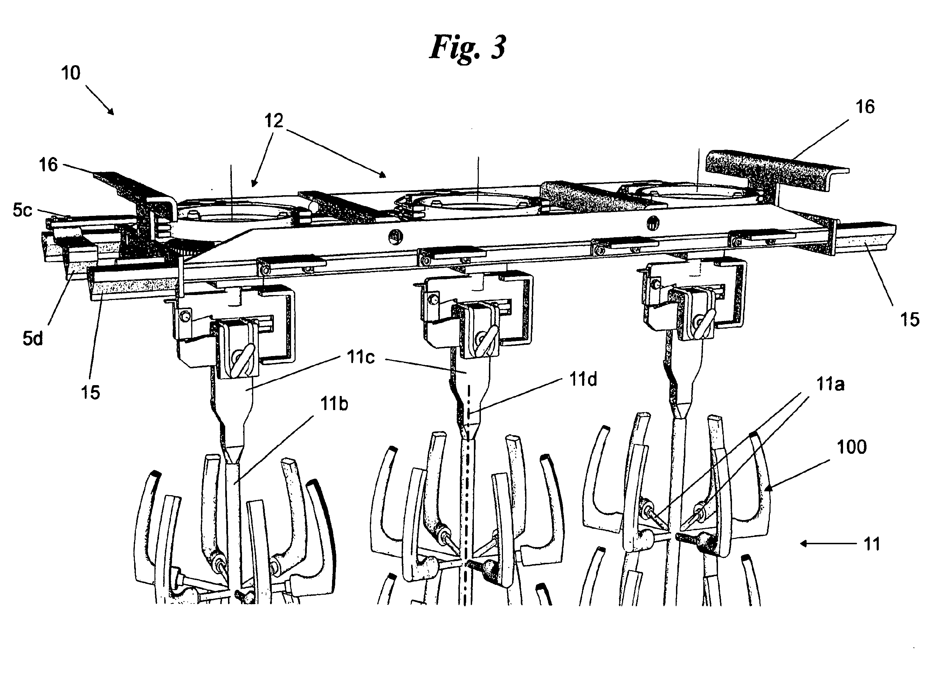

In addition, the objects 100 are disposed on appropriate frames **10,** shown in particular in Fig. 3.

They comprise at least one supporting structure **11** including a plurality of hooks **11a** for the objects 100 and preferably extending in a major extension direction **11d**.

The supporting structures 11 can be present in a varying number on each frame 10, three in number for example as shown in Fig. 3, and comprise a first electric-connection portion **5a** adapted to connect the objects 100 to a source of electric current, and an outer insulating coating **11b,** preferably of polymeric material, adapted to prevent the outer surface of the supporting structures 11 from being coated during the galvanic processes and suitably studied for being introduced into the vacuum chambers without being damaged and causing degassing problems.

The supporting structures 11 are preferably connected to movable platforms **12.**

This connection is present in the upper part **11c** of the supporting structures. This upper part 11 c is not dipped into the baths and therefore does not necessarily comprise the insulating coating 11 b.

The movable platforms 12 are adapted to be moved and to move said supporting structure 11 relative to frame 10, in particular to rotate in a direction parallel to the major extension direction 11 d of the supporting structure 11. They therefore comprise a mechanical connection **13,** such as a gear wheel **13a**, and movable electric connections **5b,** in particular of the sliding type, that are part of the electric connections 5 too, and connected to the first electric-connection portions 5a.

The movable electric connections 5b are adapted to electrically connect the movable platforms 12 to the fixed portion of frame 10.

Frames 10 then comprise second electric-connection portions **5c,** connected to the movable electric connections 5b, that are fixed relative to the latter and comprise a portion **5d** suitable for hooking, adapted to be hooked to an outer electric connection as hereinafter specified.

Frames 10 further comprise mechanical-connection means **14** adapted to be connected to the mechanical connections 13 preferably consisting of a shaft **14a** connected to a plurality of worm screws **14b** suitable to mesh with said gear wheels 13a.

Frames 10 also comprise mechanical hooks **15** adapted to secure frame 10 to further outer elements placed close to the devices 2 and 3. They preferably consist of wedge-shaped elements, so that self-alignment of same is allowed, as shown in Fig. 3. They preferably are six in number, two of which constitute the portions 5d suitable for hooking of the electric connections 5.

Finally, frames 10 comprise movable hooks **16,** adapted to allow a mechanical connection between frame 10 and the inner structure 8b of trolley 8, and in particular the hooking elements 8c.

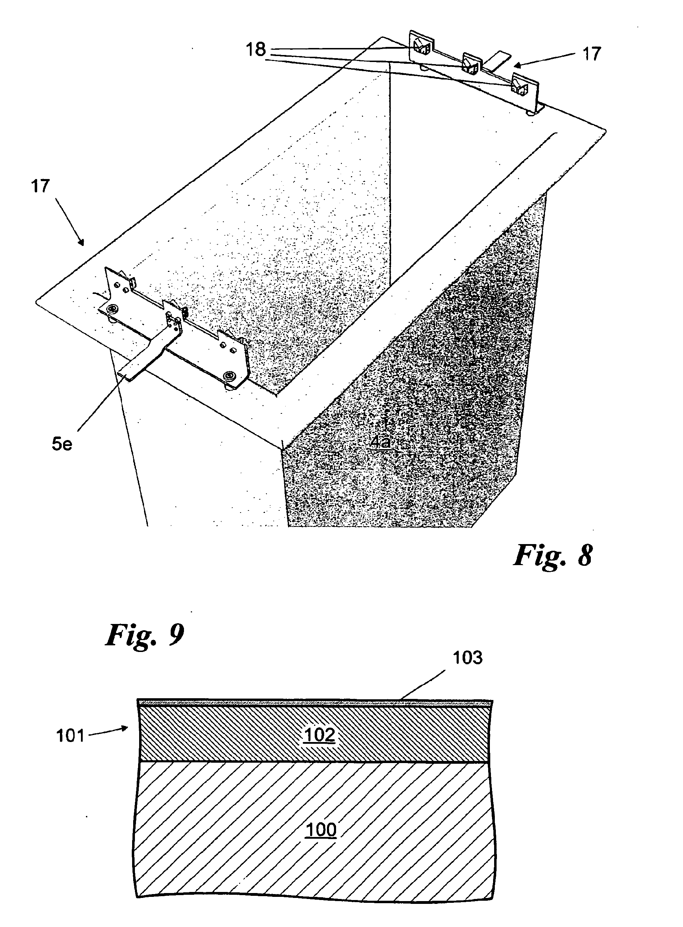

For housing frames 10, vats 4a and 6a are provided with supporting means **17** shown individually in Fig. 8 and coupled to frames 10 in Fig. 3.

They comprise first mechanical supports **18** conforming in shape to the mechanical hooks 15 and adapted to be connected to the latter, and fixed portions **5e** of the electric connections 5, adapted to be directly connected to the mains or to suitable converters connected thereto.

The device for deposition of high-vacuum coatings 3 is adapted to carry out high-vacuum coating processes, such as the previously described known PVD and CVD processes.

These processes allow deposition of the thin film 103 over the galvanic film 102, so as to give particular surface features to the objects to be coated 100, such as colour, tribologic properties and the like.

Alternatively, the device 3 for deposition of coatings in a high-vacuum environment is placed upstream of the device 2 for deposition of galvanic coatings.

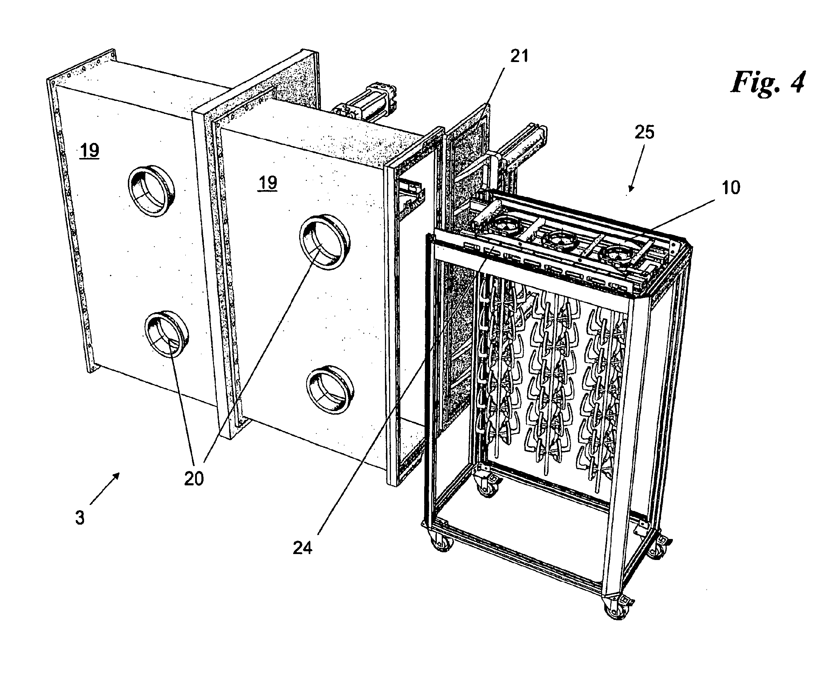

The device 3 then comprises at least one deposition chamber **19,** as shown in Fig. 4, inside which the high-vacuum can be created and comprising suitable attachments **20** either for insertion of accessories such as a vacuum pump for example or the like, or for insertion of the materials forming the particles constituting the thin film 103.

Several chambers 19 can be provided for accomplishment of several steps of the high-vacuum deposition process, in particular two chambers 19 placed in succession, or also several devices 3, adapted to enable accomplishment of several high-vacuum deposition processes simultaneously, taking into account the fact that the latter can be slower than the galvanic processes.

The deposition chambers 19 preferably have the form of a parallelepiped and comprise a door **21** consisting of a face of said parallelepiped that can be opened.

Door 21 is preferably consists of a side face, as shown in Fig. 4.

Door 21 therefore comprises automatic closing and opening means **22** consisting of electric or fluid-operated pistons.

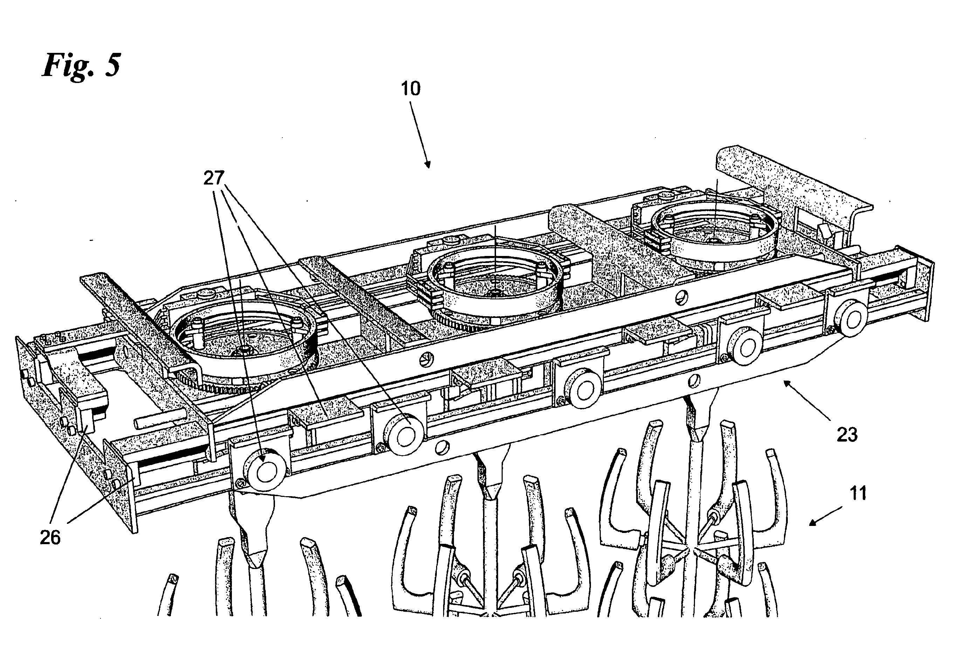

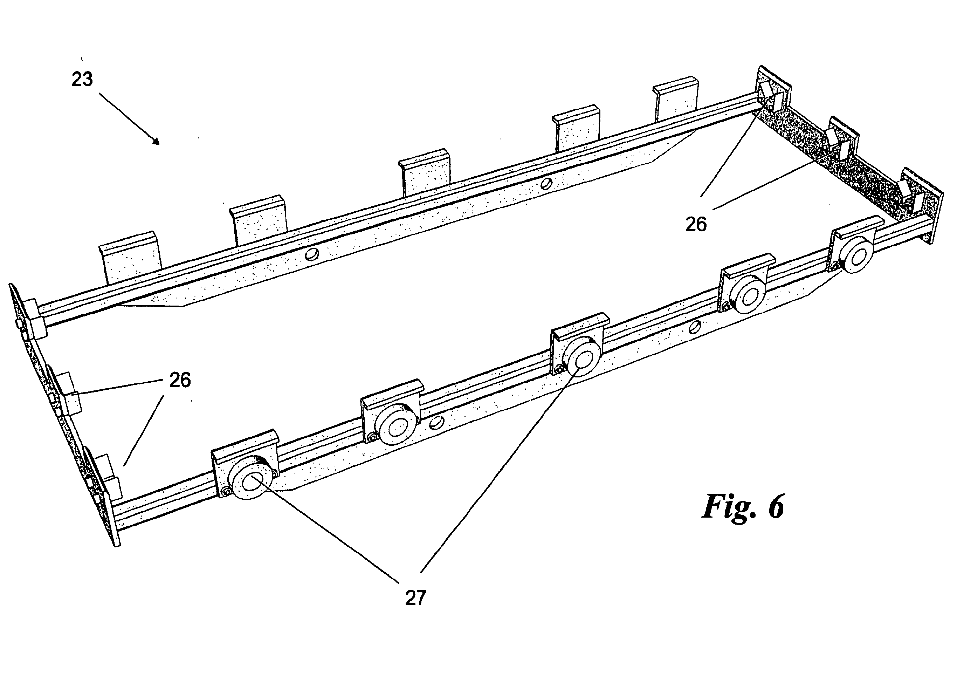

Frames 10 are inserted into chambers 19 preferably by means of a second trolley **23** (Figs. 5 and 6) that is movable on second rails **24** and extends in a horizontal plane and in a direction preferably perpendicular to the first direction 2a.

For the purpose of arranging frames 10 on the second trolleys 23 apparatus 1 comprises an intermediate station **25** adjacent and external to chamber 19, comprising the second trolley 23 disposed on a first portion of the second rails 24.

The second trolley 23 comprises second mechanical supports **26** similar to the first mechanical supports 18, which conform in shape to the mechanical hooks 15 and are adapted to be connected thereto.

It further comprises wheels or supports **27,** adapted to be disposed on the second rails 24.

The second trolley is then rigidly fastened to frames 10 and carries out translation together with the latter on rails 24.

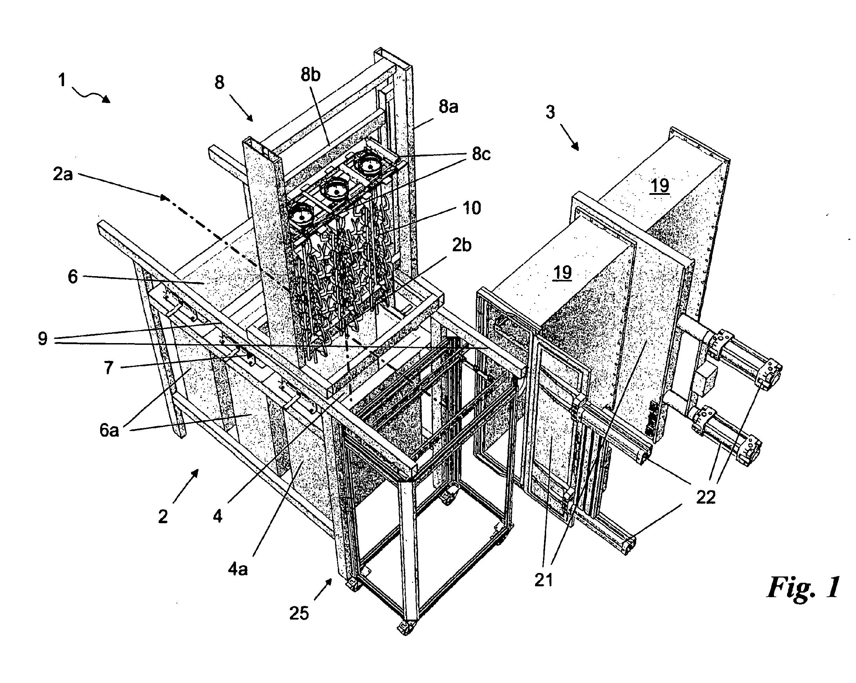

Said rails are divided into several portions, each at the inside of an individual chamber 19 or intermediate station 25, in such a manner that doors 21 can be closed without interference and trolley 23 can be moved from one portion to another, as shown in Fig. 1.

Trolley 23 is suitably moved by appropriate thrust elements (not shown) acting on the movable hooks 16, for example. It can further be connected in a movable manner to a rotation motor, in turn connected to a source of electric energy adapted to rotate shaft 14a, preferably disposed inside the individual chambers 19.

Operation of apparatus 1, described above as regards structure, is the following.

The objects 100 are disposed on the hooks 11a of the vertical structure 11, placed on frame 10.

Frame 10 is then placed on the first trolley 8 carrying the frame itself inside the further vats 6a, for cleaning or pickling of the objects 100 and inside the first vat 4a, in the electrolytic bath 4.

Trolley 8 carries frame 10 and hooks the movable hooks 16 thereof by means of the hooking elements 8c releasing the same at the supporting means 17 placed on vats 4a and 6a.

When the objects 100 are within the electrolytic bath 4, an electric field is applied to the same by means of the electric connections 5 so that they will constitute a cathode for the oxidation-reduction reaction taking place in the galvanic processes.

In the same electrolytic bath 4 also an anode is placed, which is connected to a source of electric current too and is made of the same material as the material that is intended to be used for the galvanic film 102.

When anode and cathode are electrically activated, following an oxidation-reduction reaction, metal atoms lay down on the cathode thus forming the galvanic films on the objects 100.

When the galvanic process has been completed, the first trolley 8 carries frame 10 onto the intermediate station 25.

Frame 10 is then rigidly linked to the second trolley 23 (Fig. 5) and is therefore adapted to slide on the second rails 24.

The first door 21 is then opened and frame 10 linked to the second trolley 23 is conveyed by means of said thrust elements into the first deposition chamber 19.

Door 21 is then automatically closed by the closing and opening means 22 and in chamber 19 the vacuum is created.

At this point the high-vacuum processes such as PVD or CVD processes are applied and the thin film 103 is formed over the galvanic film 102.

During the high-vacuum processes the supporting structures 11 are moved around the movable platforms 12.

In fact, in said high-vacuum processes, the materials that have to constitute the film, or the precursors of same, are made available within the volume of chamber 19 under vacuum, in the form of gases, vapours and/or particles for example. The particles or the like present within chamber 19 therefore come into contact with the objects to be coated 100 to which they adhere in a uniform manner if the objects themselves are set in motion, in particular in a rotary, translatory or roto-translatory motion.

Possibly, frame 10 linked to the second trolley 23 is conveyed, by means of further thrust elements, into the second deposition chamber 19 with a further opening-closing movement of the second door 21.

The invention enables important advantages to be achieved.

In fact, device 1 enables coating films 101 made up of galvanic films 102 and thin films 103 as described, to be obtained quickly, practically in a continuous manner, due to the automatic interfacing 25 of the galvanic plant and the vacuum plant that is placed in line too.

The process takes place quickly, in particular due to the important fact that one only type of frame 10 is adapted to support the objects 100 both during the galvanic and the high-vacuum processes and to the fact that frames 10 are coated with plastic materials that are able to withstand both dipping into the galvanic baths and the vacuum conditions of the PVD and/or CVD processes.

It is therefore possible to coat the objects 100 with films 101 having high protection properties against corrosion and suitable surface features, such as the desired colour and particular tribologic properties.

At the same time it is possible to greatly reduce the number of production rejections.

In addition, with said process some galvanic baths that have a high environmental impact and are harmful to the operators' health and the environment, can be partly replaced, such as the chromium plating baths involving use of hexavalent chromium which are replaced with metal chromium laid down under vacuum and therefore without risks.

In particular, it is possible to put into practice a galvanic process for obtaining a galvanic film 102 made of materials of the traditional type, in particular nickel, and a subsequent high-vacuum coating, in particular of the PVD type, so as to form a thin film 103 constituting the outer surface of the objects of pure chromium or chromium compounds.

This high-vacuum coating of chromium is suitably obtained with 99% pure chromium, which is a safe product for workers and environment.

Said process gives aesthetic and surface features even better than chromium plating obtained with hexavalent chromium and does not show the related toxicity drawbacks during working.

In addition, it is suitably put into practice using the previously described apparatus 1.

The invention is susceptible of the following variation.

The deposition chambers 19 can have an opening on top, so that the first trolley 8 can transfer the objects 100 also to the inside of the chambers 19 themselves without the intermediate station 25 being required.

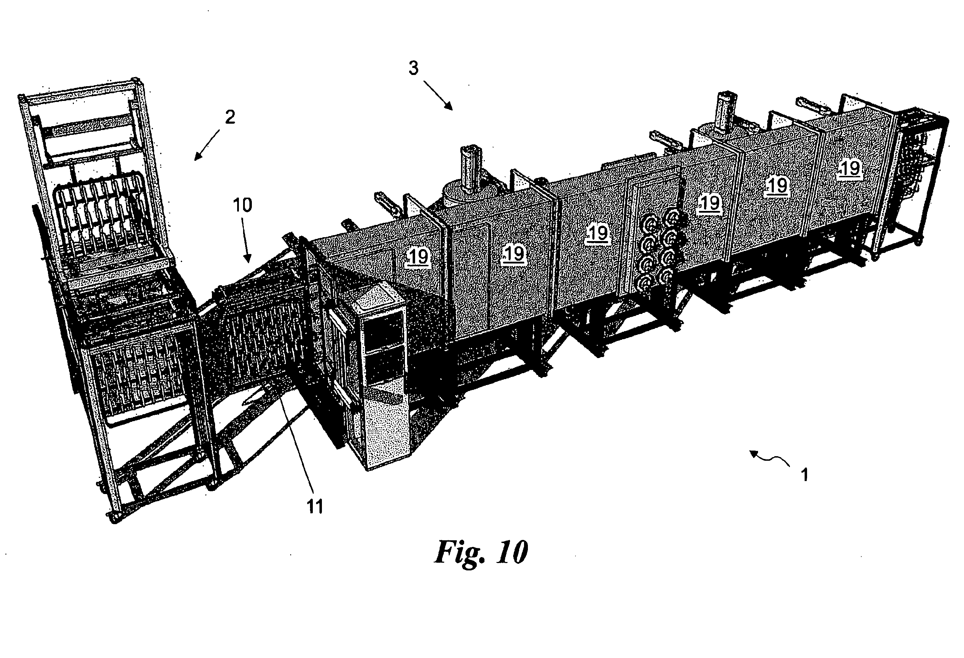

In addition, as shown in a second example represented in Fig. 10, frames 10 comprise supporting structures 11 that are fixed relative to frame 10.

In this case frame 10 preferably moves inside the deposition chambers 19 and the rotary and/or roto-translatory motion is not necessary.

The supporting structures, in the last-mentioned case, preferably have a square shape, as shown in Fig. 10.

All of the details can be replaced by equivalent elements and the materials, shapes and sizes can be of any nature and magnitude.

## Claims

1. An apparatus (1) for deposition of coating films (101) on objects to be coated (100), comprising:
- a device for deposition of galvanic coatings (2) adapted to lay down galvanic films (102) and including a plurality of vats (4a, 6a) and a first trolley (8) adapted to cause translation of a frame (10) between said vats (4a, 6a),
- at least one device for deposition of high-vacuum coatings (3), adapted to lay down thin films (103) and including at least one deposition chamber (19) suitable for creation of a high-vacuum inside it,
- at least one frame (10) adapted to support said objects to be coated (100), said frame (10) being suitable to be positioned both on said device for deposition of galvanic coatings (2) and within said device for deposition of high-vacuum coatings (3).
**characterised in that**
- said device for deposition of high-vacuum coatings (3) comprises a second trolley (23) that can be fastened to said frame (10) and is movable on second rails (24), said second trolley (23) being adapted to allow entry and exit of said frame (10) into and out of said at least one deposition chamber (19).
- said first trolley (8) being also suitable to cause translation of said frame (10) between said vats (4a, 6a) and said second trolley (23).

2. An apparatus (1) as claimed in claim 1, wherein said device for deposition of galvanic coatings (2) and said at least one device for deposition of high-vacuum coatings (3) are placed in succession.

3. An apparatus (1) as claimed in one or more of the preceding claims, wherein said galvanic films (102) are laid down on said objects to be coated (101) and wherein said thin films (103) are laid down on said galvanic films (102).

4. An apparatus (1) as claimed in one or more of the preceding claims, wherein said frame (10) comprises at least one supporting structure (11) connected to a movable platform (12) adapted to be moved in an integral manner with said supporting structure (11) and relative to said frame (10).

5. An apparatus (1) as claimed in claim 4, wherein said supporting structure (11) has a major extension direction and wherein said movable platform (12) is adapted to rotate in a direction parallel to said major extension direction (11d).

6. An apparatus (1) as claimed in claim 4 or 5, wherein said supporting structure (11) comprises an outer insulating coating (11b) adapted to resist both inside said device for deposition of galvanic coatings (2) and inside said device for deposition of high-vacuum coating (3).

7. An apparatus (1) as claimed in one or more of the preceding claims, wherein said first trolley (8) is adapted to cause translation of said frame (10) in a first horizontal direction (2a) so as to enable translation of said frame (10) between said vats (4a, 6a), and in a vertical direction (2b), in a manner adapted to allow at least partial dipping of said frame (10) into said vats (4a, 6a) and removal therefrom.

8. An apparatus (1) as claimed in claim 8, wherein said deposition chamber (19) substantially has the form of a parallelepiped and comprises a door (21) consisting of a face of said parallelepiped that can be opened.

9. An apparatus (1) as claimed in one or more of the preceding claims, comprising an intermediate station (25) adjacent and external to said at least one deposition chamber (19) and comprising said second trolley (23) disposed on a first portion of said second rails (24).

## Patentansprüche

1. Vorrichtung (1) zur Abscheidung von Überzugschichten (101) auf zu beschichtende Gegenstände (100), die Folgendes umfasst:
eine Einheit zur Abscheidung von galvanischen Schichten (2) angepasst zur Aufbringung galvanischer Schichten (102) und mit einer Vielzahl an Gefäßen (4a, 6a) und einem ersten Wagen (8), angepasst, um die Verschiebung eines Rahmens (10) zwischen den genannten Gefäßen (4a, 6a) zu erzeugen,
mindestens eine Einheit zur Abscheidung von Hochvakuumschichten (3), angepasst, um dünne Schichten (103) aufzubringen und mit mindestens einer Abscheidungskammer (19), die für die Erzeugung eines Hochvakuums im Inneren geeignet ist,
mindestens einen Rahmen (10), angepasst, um die genannten zu beschichtenden Gegenstände zu tragen (100), wobei der genannte Rahmen (10) geeignet ist, sowohl auf der genannten Einheit zur Abscheidung der galvanischen Schichten (2) als auch in der genannten Einheit zur Abscheidung der Hochvakuumschichten (3) positioniert zu werden,
**dadurch gekennzeichnet, dass**
die genannte Einheit zur Abscheidung von Hochvakuumschichten (3) einen zweiten Wagen (23) umfasst, der am genannten Rahmen (10) befestigt und auf zweiten Schienen (24) bewegt werden kann, wobei der genannte Wagen (23) so angepasst ist, dass das Ein- und Austreten des genannten Rahmens (10) in und aus der genannten mindestens einen Abscheidungskammer (19) ermöglicht wird,
der genannte erste Wagen (8) auch in der Lage ist, die Verschiebung des genannten Rahmens (10) zwischen den genannten Gefäßen (4a, 6a) und dem genannten zweiten Wagen (23) zu erzeugen.

2. Vorrichtung (1) nach Anspruch 1, in dem die genannte Einheit zur Abscheidung der galvanischen Schichten (2) und die genannte mindestens eine Einheit zur Abscheidung von Hochvakuumschichten (3) nacheinander platziert werden.

3. Vorrichtung (1) nach einem oder mehreren der vorangegangenen Ansprüche, in dem die genannten galvanischen Schichten (102) auf die zu beschichtenden genannten Gegenstände (101) aufgebracht werden und in dem die genannten dünnen Schichten (103) auf die genannten galvanischen Schichten (102) aufgebracht werden.

4. Vorrichtung (1) nach einem oder mehreren der vorangegangenen Ansprüche, in der der genannte Rahmen (10) mindestens eine Trägerstruktur (11) umfasst, die mit einer beweglichen Plattform (12) verbunden ist, die angepasst wurde, um vollständig mit der genannten Trägerstruktur (11) und in Bezug auf den genannten Rahmen (10) bewegt zu werden.

5. Vorrichtung (1) nach Anspruch 4, in der die genannte Trägerstruktur (11) eine größere Ausdehnungsrichtung aufweist und in der die genannte bewegliche Plattform (12) angepasst wurde, um in eine Richtung parallel zur genannten größeren Ausdehnungsrichtung zu drehen (11d).

6. Vorrichtung (1) nach Anspruch 4 oder 5, in der die genannte Trägerstruktur (11) eine äußere Isolierschicht (11 b) umfasst, angepasst , um sowohl in der genannten Einheit zur Abscheidung der galvanischen Schichten (2) als auch in der genannten Einheit zur Abscheidung der Hochvakuumschicht (3) standzuhalten.

7. Vorrichtung (1) nach einem oder mehreren der vorangegangenen Ansprüche, in der der genannte erste Wagen (8) angepasst wird, um die Verschiebung des genannten Rahmens (10) in eine erste horizontale Richtung (2a) zu erzeugen, um die Verschiebung des genannten Rahmens (10) zwischen den Gefäßen (4a, 6a) zu ermöglichen und in einer vertikalen Richtung (2b), so angepasst, dass zumindest das teilweise Eintauchen des genannten Rahmens (10) in die genannten Gefäße (4a, 6a) und das Entfernen daraus ermöglicht wird.

8. Vorrichtung (1) nach Anspruch 8, in dem die genannten Abscheidungskammer(19) im Wesentlichen eine Parallelopipedform aufweist und eine Tür (21) umfasst, die aus einer Seite des genannten Parallelopipeds besteht, die geöffnet werden kann.

9. Vorrichtung (1), nach einem oder mehreren der vorangegangenen Ansprüche, die eine Zwischenstation (25) umfasst, die an die genannte mindestens eine Abscheidungskammer (19) angrenzt und den genannten zweiten Wagen (23) umfasst, der sich in einem ersten Abschnitt der genannten zweiten Schienen (24) befindet.

## Revendications

1. Dispositif (1) pour le dépôt de films de revêtement (101) sur des objets à revêtir (100) **caractérisé en ce qu'**il comprend :
- un dispositif pour le dépôt de revêtements galvaniques (2) adapté pour le dépôt de films galvaniques (102) et incluant une pluralité de cuves (4a, 6a) et un premier chariot (8) adapté pour causer la translation d'un cadre (10) entre lesdites cuves (4a, 6a),
- au moins un dispositif pour le dépôt de revêtement à vide poussé (3), adapté pour le dépôt de films minces (103) et incluant au moins une chambre de dépôt (19) appropriée à la création d'un vide poussé à son intérieur,
- au moins un cadre (10) adapté pour le support desdits objets à revêtir (100), ledit cadre (10) étant approprié à être positionné tant sur ledit dispositif pour le dépôt de films galvaniques (2) qu'à l'intérieur dudit dispositif pour le dépôt de revêtements à vide poussé (3).
**caractérisé en ce que**
- ledit dispositif pour le dépôt de revêtements à vide poussé (3) comprend un second chariot (23) qui peut être fixé au dit cadre (10) et qui peut être déplacé sur des seconds rails (24), ledit second chariot (23) étant adapté pour permettre l'entrée et la sortie dudit cadre (10) dans et hors de ladite au moins une chambre de dépôt (19).
- ledit premier chariot (8) étant également approprié à causer la translation dudit cadre (10) entre lesdites cuves (4a, 6a) et ledit second chariot.

2. Dispositif (1) selon la revendication 1, dans lequel ledit dispositif pour le dépôt de revêtements galvaniques (2) et ledit au moins un dispositif pour le dépôt de revêtements à vide poussé (3) sont placés en succession.

3. Dispositif (1) selon l'une quelconque des revendications précédentes, dans lequel lesdits films galvaniques (102) sont déposés sur lesdits objets à revêtir (101) et dans lequel lesdits films minces (103) sont déposés sur lesdits films galvaniques (102).

4. Dispositif (1) selon l'une quelconque des revendications précédentes, dans lequel ledit cadre (10) comprend au moins une structure de support (11) connectée à une plate-forme mobile (12) adaptée pour être mise en mouvement d'une manière intégrale avec ladite structure de support (11) et ledit cadre correspondant (10).

5. Dispositif (1) selon la revendication 4, dans lequel ladite structure de support (11) a la plus grande direction d'extension et dans lequel ladite plate-forme mobile (12) est adaptée pour tourner dans une direction parallèle à ladite plus grande direction d'extension (11d).

6. Dispositif (1) selon les revendications 4 ou 5, dans lequel ladite structure de support (11) comprend un revêtement isolant externe (11b) adapté pour résister tant à l'intérieur dudit dispositif pour le dépôt de revêtements galvaniques (2) qu'à l'intérieur dudit dispositif pour le dépôt de revêtements à vide poussé (3).

7. Dispositif (1) selon l'une quelconque des revendications précédentes, dans lequel ledit premier chariot (8) est adapté pour causer la translation dudit cadre (10) dans une première direction horizontale (2a) de façon à activer la translation dudit cadre (10) entre lesdites cuves (4a, 6a) et en direction verticale (2b), d'une manière adaptée pour permettre au moins une immersion partielle dudit cadre (10) dans lesdites cuves (4a, 6a) et le retrait de celles-ci.

8. Dispositif (1), selon la revendication 8, dans lequel ladite chambre de dépôt (19) a fondamentalement la forme d'un parallélépipède et comprend une porte (21) consistant en une face dudit parallélépipède qui peut être ouverte.

9. Dispositif (1) selon l'une quelconque des revendications précédentes, comprenant une station intermédiaire (25) adjacente et externe à ladite au moins une chambre de dépôt (19) et comprenant ledit second chariot (23) disposé sur une première partie desdits seconds rails (24).
